# EUROPÄISCHE PATENTSCHRIFT

(11) **EP 1 463 393 B1**
(45) Veröffentlichungstag und Bekanntmachung des Hinweises auf die Patenterteilung: **06.12.2006**
(21) Anmeldenummer: 03007172.4
(22) Anmeldetag: 28.03.2003
(51) Int. Cl.: H05K 7/02

(54) **Halbleiterrelais**
Semiconductor relay
Relais à semi-conducteur

(43) Veröffentlichungstag der Anmeldung: 29.09.2004
(73) Patentinhaber: SIEMENS AKTIENGESELLSCHAFT, 80333 München (DE)
(72) Erfinder: Apfelbacher, Walter, 92271 Freihung (DE); Lehmeier, Annemarie, 92289 Ursensollen (DE); Seitz, Johann, 92224 Amberg (DE)

(56) Entgegenhaltungen:
- DE-A- 19 726 637
- DE-U- 8 105 438
- DE-U- 29 802 548
- US-A- 3 594 689
- US-A- 5 997 362

## Beschreibung

Die Erfindung betrifft ein Halbleiterrelais mit einem im Wesentlichen quaderförmigen Gehäuse. Ein Halbleiterrelais ist beispielsweise aus der DE 199 56 445 C2 bekannt.

Ein Halbleiterrelais oder Halbleiterschütz weist Anschlüsse für einen Haupt- oder Laststromkreis und für einen Steuerstromkreis auf. Sollen zusätzliche Funktionen, beispielsweise eine Überwachungs- oder Messfunktion bereitgestellt werden, so wird dies üblicherweise mit Hilfe eines zusätzlichen Gerätes realisiert, welches mit dem entsprechenden Stromkreis bzw. den entsprechenden Stromkreisen verbunden wird. Hierbei können insbesondere für verschiedene Überwachungsfunktionen unterschiedliche Geräte vorgesehen sein, wobei die Laststromkreisanforderungen vom Einsatz dieser Geräte unabhängig sind. Die Mehrzahl der optional zu verwendenden Geräte bedeutet einen erheblichen Mehraufwand bei Projektierung, Lagerhaltung, Montage und Inbetriebnahme im Vergleich zur Verwendung ausschließlich eines Halbleiterrelais oder Halbleiterschützes. Weiterhin ist der Platzbedarf der zusätzlich zum Relais oder Schütz in einem Schaltschrank zu installierenden Geräte von Bedeutung.

Der Erfindung liegt die Aufgabe zugrunde, mit besonders geringem Installationsaufwand und Platzbedarf Zusatzfunktionen in ein Halbleiterrelais oder ein Halbleiterschütz aufweisenden Stromkreisen zu realisieren.

Diese Aufgabe wird erfindungsgemäß gelöst durch ein Halbleiterrelais mit den Merkmalen des Anspruchs 1, durch ein Funktionsmodul mit den Merkmalen des Anspruchs 4 und mit einer Vorrichtung mit den Merkmalen des Anspruchs 10.

Der Begriff Halbleiterrelais umfasst hierbei auch üblicherweise als Halbleiterschütze bezeichnete Geräte. Das Halbleiterrelais weist ein im Wesentlichen quaderförmiges Gehäuse an einer Haltevorrichtung, insbesondere einer Tragschiene, oder an einem Kühlkörper befestigbar ist. Die übrigen fünf Seiten des Gehäuses werden zusammenfassend als Anschlussseiten bezeichnet. An einer oder mehrerer dieser Seiten sind elektrische Anschlüsse vorgesehen. Mit mindestens einer der Anschlussseiten ist ein auf das Gehäuse aufsetzbares Funktionsmodul verbindbar. Vorzugsweise kontaktiert ein einziges Funktionsmodul das Gehäuse an mehreren Seiten, insbesondere an einer senkrecht zur Befestigungsseite angeordneten Seitenfläche sowie an einer der Befestigungsseite gegenüberliegenden Frontseite. Hierbei kann beispielsweise vorgesehen sein, dass eine Seite des Gehäuses mit einer Seite des Funktionsmoduls lediglich mechanisch verbunden ist, während eine weitere Seite des Gehäuses mit einer weiteren Seite des Funktionsmoduls sowohl mechanisch als auch elektrisch verbunden ist. Das Funktionsmodul ist mit dem Steuerstromkreis und/oder Laststromkreis des Halbleiterrelais verbunden.

Die Verbindung des Funktionsmoduls mit dem Gehäuse des Halbleiterrelais ist vorzugsweise werkzeuglos herstellbar sowie lösbar, insbesondere mittels einer Schnappverbindung. Alternativ oder zusätzlich kann jedoch beispielsweise auch eine Schraubverbindung vorgesehen sein. Vorzugsweise sind an ein einziges Gehäuse eines Halbleiterrelais mehrere Funktionsmodule ankoppelbar. Ebenso kann die Verbindung zwischen mehreren Funktionsmodulen vorgesehen sein.

Das auf das Relaisgehäuse aufsetzbare Funktionsmodul ist vorzugsweise nicht breiter - bezogen auf die Erstreckung einer Tragschiene - als das Gehäuse selbst, so dass die Anordnung aus Halbleiterrelais und Funktionsmodul praktisch keinen zusätzlichen Raum in einem Schaltschrank benötigt. Das Funktionsmodul zeichnet sich auch dadurch aus, dass es auf sehr einfache Weise in bestehenden Schaltanlagen nachrüstbar ist.

Die mechanische und die elektrische Verbindung des Funktionsmoduls mit dem Halbleiterrelais kann nacheinander oder gleichzeitig erfolgen. Das Herstellen der elektrischen Verbindung zwischen dem Funktionsmodul und dem Halbleiterrelais mit der Verbindung der jeweiligen Gehäuse minimiert den Verdrahtungsaufwand und stellt gleichzeitig eine Sicherung gegen Verdrahtungsfehler dar. Hierbei sind im Gehäuse des Halbleiterrelais sowie im Funktionsmodul korrespondierende Kontaktierungselemente, beispielsweise Federkontakte vorgesehen, die eine Kontaktierung der Ansteuerelektronik des Halbleiterrelais ermöglichen, wodurch das Funktionsmodul direkt Einfluss auf die Ansteuerung im Halbleiterrelais nehmen kann. Die elektrischen Eigenschaften des mit dem Funktionsmodul erweiterten Halbleiterrelais sind vorzugsweise identisch mit den Eigenschaften eines Abzweigs ohne zusätzliche Funktionen. Diese Unabhängigkeit der elektrischen Eigenschaften des Haupt- oder Laststromkreises vom Vorhandensein und den Eigenschaften des Funktionsmoduls bedeutet eine rationelle Projektierung sowie erhebliche Einsparungen bei der Lagerhaltung. Insgesamt ist mit dem Halbleiterrelais und den mit diesen kompatiblen Funktionsmodulen eine durchgängig und modular ausbaubare Produktfamilie gegeben, wobei das Halbleiterrelais auch ohne mit diesem verbundenes Funktionsmodul uneingeschränkt einsatzfähig ist.

Um den in einem Schaltschrank zur Montage des Funktionsmoduls zur Verfügung stehenden, an das Halbleiterrelais grenzenden Raum besonders gut auszunutzen, weist das Funktionsmodul nach einer bevorzugten Ausgestaltung nicht nur einen an die Frontseite des Halbleiterrelais anschließenden Teil, sondern auch einen an eine Seitenfläche, nämlich eine parallel zur Tragschiene ausgerichtete Seitenfläche anschließenden Teil auf. Der letztgenannte Teil weist dabei eine so genannte Basisseite auf, welche mit der Befestigungsseite des Halbleiterrelais zumindest annähernd fluchtet. Dieser Basisseite liegt an der Vorderseite des Funktionsmoduls bevorzugt eine Steckverbindungsleiste gegenüber.

Weist das Gehäuse des Halbleiterrelais eine Öffnung auf, welche auch bei aufgesetztem Funktionsmodul zugänglich bleiben sollte, so sind gemäß einer bevorzugten Ausführungsform beidseitig der Öffnung zwei Befestigungsschenkel am Funktionsmodul angeformt, welche vorzugsweise zur Herstellung einer Schnappverbindung zwischen dem Funktionsmodul und dem Gehäuse des Halbleiterrelais vorgesehen sind. Die Befestigungsschenkel sind dabei, sofern sich die Öffnung an der Frontseite des Gehäuses befindet, parallel zu zwei Seitenflächen des Gehäuses ausgerichtet, wobei die Schnappverbindungselemente der Befestigungsschenkel an einer Kante zwischen der Frontseite und einer Seitenfläche des Gehäuses des Halbleiterrelais mit diesem verrastbar sind.

Das Funktionsmodul kann beispielsweise eine oder mehrere folgende Funktionen umfassen: Überwachung des Laststromkreises, Leistungsregelung im Laststromkreis, Strommessung, Analog-Digital-Signalwandlung. Das Funktionsmodul kann mittels analoger und/oder digitaler Signale ansteuerbar sein. Der Vorteil der Erfindung liegt insbesondere darin, dass durch vorkonfektionierte und/oder nachrüstbare auf ein Halbleiterrelais oder ein Halbleiterschütz aufschnappbare Funktionsmodule die Funktionalität des Relais auf einfache Weise modular erweiterbar ist und/oder Zusatzfunktionen bevorzugt im Steuerstromkreis realisierbar sind.

Nachfolgend werden mehrere Ausführungsbeispiele der Erfindung anhand einer Zeichnung näher erläutert. Hierin zeigen:
- FIG 1 bis 3: jeweils ein Ausführungsbeispiel eines Funktionsmoduls für ein Halbleiterrelais,
- FIG 4: ein Halbleiterrelais und ein mit diesem verbindbares Funktionsmodul,
- FIG 5 bis 8: jeweils ein Ausführungsbeispiel eines Halbleiterrelais,
- FIG 9: mehrere Halbleiterrelais und mit diesen zusammenwirkende Funktionsmodule, und
- FIG 10: ein Halbleiterrelais und mehrere schematisch dargestellte Funktionsmodule.

Einander entsprechende Teile sind in allen Figuren mit den gleichen Bezugszeichen versehen.

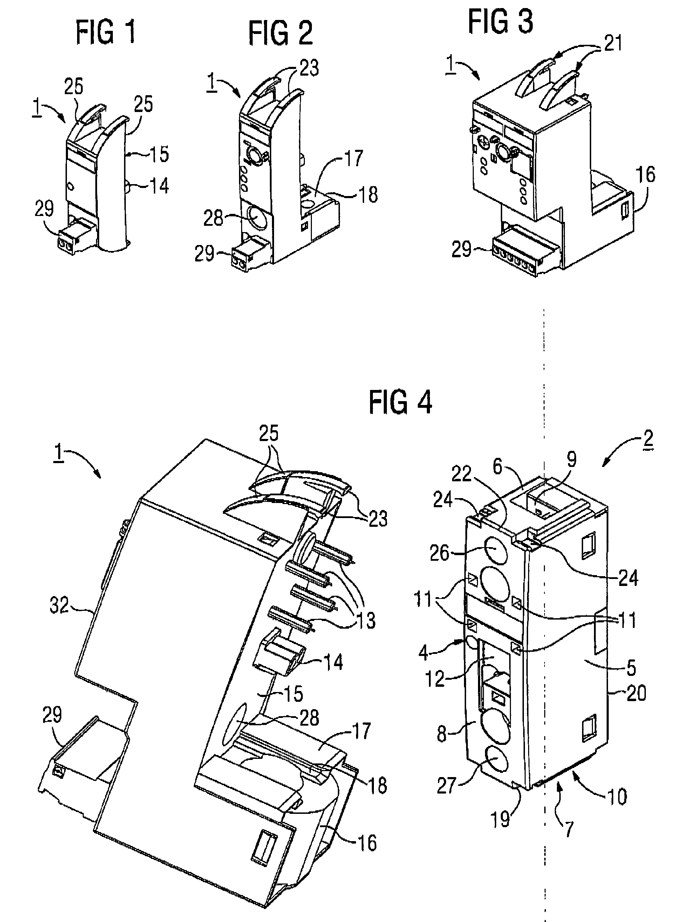

Die FIG 1 bis 3 zeigen jeweils eine Ausführungsform eines Funktionsmoduls 1 für ein Halbleiterrelais oder ein Halbleiterschütz. Das Funktionsmodul 1 greift zumindest in den Steuerstromkreis des Halbleiterrelais ein und ersetzt herkömmliche Geräte, die zur Ansteuerung eines Halbleiterrelais mit diesem zu verdrahten sind. Die FIG 4 zeigt das auch in FIG 3 dargestellte Funktionsmodul 1 zusammen mit einem zugehörigen Halbleiterrelais 2. Das Halbleiterrelais 2 weist eine zur Befestigung an einer tragenden Struktur vorgesehene Befestigungsseite 3, zwei Längsseiten 4,5 und zwei Querseiten 6,7, zusammenfassend als Seitenflächen 4,5,6,7 bezeichnet, sowie eine der Befestigungsseite 3 gegenüberliegende Frontseite 8 auf. Die Längs- und Querseiten 4,5,6,7 und die Frontseite 8 werden einheitlich auch als Anschlussseiten bezeichnet, wobei im dargestellten Ausführungsbeispiel an den Längsseiten 4,5, keine Anschlüsse vorgesehen sind. Das aus einem Kunststoff hergestellte Gehäuse des Halbleiterrelais 2 weist eine im Wesentlichen quaderförmige Gestalt auf und trägt das Bezugszeichen 20. Von den Querseiten 6,7 des Gehäuses 20 aus sind dem Haupt- oder Laststromkreis zugeordnete Hauptanschlüsse 9,10 zugänglich, während von der Frontseite 8 aus mehrere Anschlussbuchsen 11,12 zugänglich sind. In die Anschlussbuchsen 11,12 als elektrische Verbindungselemente greifen Stifte 13 bzw. ein Stecker 14 des Funktionsmoduls 1 ein. Die Stifte 13 kontaktieren nicht sichtbare Kontaktflächen im Halbleiterrelais 2 und bilden Federkontakte. Sämtliche elektrischen Verbindungselemente zwischen dem Halbleiterrelais 2 und dem Funktionsmodul 1 befinden sich damit an der Frontseite 8 bzw. einer mit dieser korrespondierenden Kontaktierungsseite 15 des Funktionsmoduls 1 oder sind von der jeweiligen Seite 8,15 aus zugänglich. Eine zusätzliche Verdrahtung zwischen dem Funktionsmodul 1 und dem Halbleiterrelais 2 ist nicht erforderlich. Das Halbleiterrelais 2 ist je nach Anforderungen mit unterschiedlichen Funktionsmodulen 1 kombinierbar. Sofern das Funktionsmodul 1, welches beispielsweise zur Stromregelung im Laststromkreis vorgesehen ist, sowohl steuerstromseitig als auch laststromseitig mit dem Halbleiterrelais 2 zu verbinden ist, sind diese Verbindungen mit dem Aufschnappen des Funktionsmoduls 1 auf das Halbleiterrelais 2 automatisch hergestellt. Die Gefahr einer Fehlkontaktierung ist somit prinzipbedingt ausgeschlossen.

Die in den FIG 2 bis 4 dargestellten Funktionsmodule 1 weisen im Wesentlichen eine L-Form auf, wobei der erste, längere L-Schenkel an der Frontseite 8 des Halbleiterrelais 2 und der zweite, kürzere L-Schenkel an der Querseite 7 anliegt. Letztgenannter L-Schenkel ist begrenzt durch eine Basisseite 16, welche in gerader Verlängerung der Befestigungsseite 3 des Halbleiterrelais 2 angeordnet ist. Rechtwinklig zur Basisseite 16 verläuft, an die Querseite 7 angrenzend, eine Fixierseite 17 des Funktionsmoduls 1, welche eine Nut 18 aufweist, die mit einer als korrespondierendes mechanisches Verbindungselement dienenden Schiene 19 auf der Querseite 7 des Gehäuses 20 des Halbleiterrelais 2 zusammenwirkt. Das Funktionsmodul 1, dessen Gehäuse 32 ebenso wie das das Gehäuse 20 des Halbleiterrelais 2 aus Kunststoff gefertigt ist, ist somit auf dieses aufschiebbar. Auf der gegenüberliegenden Querseite 6 ist eine Schnappverbindung 21 vorgesehen, welche das Funktionsmodul 1 an einer Kante 22 des Gehäuses 20 fixiert. Die Schnappverbindung 21 wird gebildet aus zwei Schnapphaken 23, welche in weitere mechanische Verbindungselemente bildende Vertiefungen 24 auf der Querseite 6 einrasten. Die Schnapphaken 23 sind federnd angeformt an jeweils einem Befestigungsschenkel 25 am Funktionsmodul 1, welcher parallel zu den Längsseiten 4,5 ausgerichtet ist. Zwischen den Befestigungsschenkeln 25 verbleibt ein Freiraum, um die Zugänglichkeit einer dem Hauptanschluss 9 zugeordneten Öffnung 26 des Gehäuses 20 auch bei auf dieses aufgeschnapptem Funktilichkeit einer dem Hauptanschluss 9 zugeordneten öffnung 26 des Gehäuses 20 auch bei auf dieses aufgeschnapptem Funktionsmodul 1 zu gewährleisten. Eine weitere, dem Hauptanschluss 10 zugeordnete Öffnung 27 im Gehäuse 20 ist durch eine Betätigungsöffnung 28 im Gehäuse 32 des Funktionsmoduls 1 zugänglich. Frontseitig des Funktionsmoduls 1 befindet sich eine Steckverbindungsleiste 29, welche der Basisseite 16 gegenüberliegt.

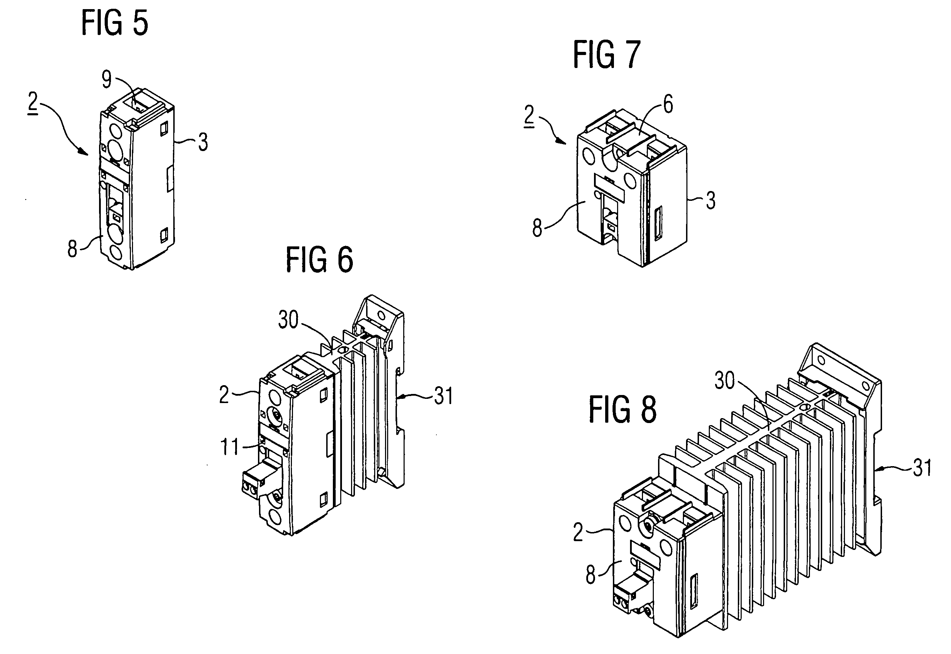

Die FIG 5 bis 8 zeigen jeweils ein Halbleiterrelais 2, wobei die in FIG 5 dargestellte Ausführungsform der Bauform nach FIG 4 entspricht. In den FIG 6 und 8 ist jeweils ein ebenfalls unter dem Begriff Halbleiterrelais subsumiertes, an einem Kühlkörper 30 befestigtes Halbleiterschütz 2 dargestellt. Der Kühlkörper weist rückseitig, d.h. dem Halbleiterrelais 2 gegenüberliegend, eine Aussparung 31 auf, mittels derer eine Befestigung des Relais 2 an einer nicht dargestellten Tragschiene, die normal zu den Längsseiten 4,5 verläuft, möglich ist.

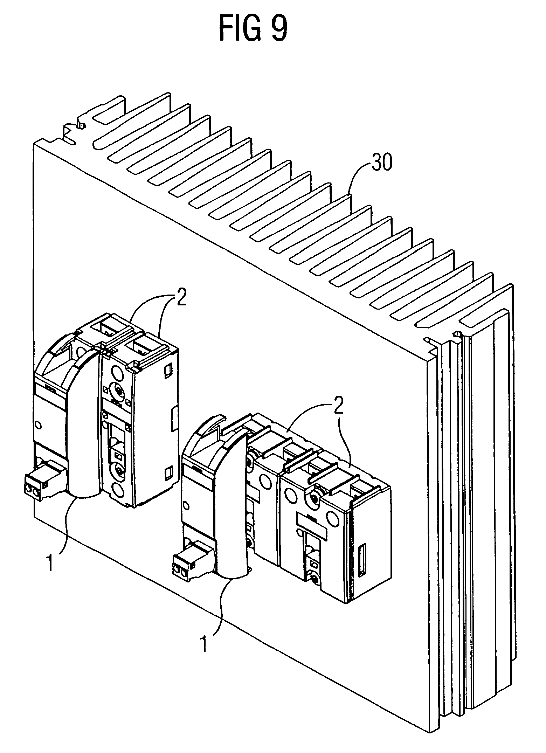

Im Ausführungsbeispiel nach FIG 9 sind mehrere Halbleiterrelais 2 an einem gemeinsamen Kühlkörper 30 befestigt. Beispielhaft sind des Weiteren zwei Funktionsmodule 1 in der Bauform nach FIG 1 dargestellt, von welchen eines auf ein Halbleiterrelais 2 aufgeschnappt ist. Zum Aufschnappen des Funktionsmoduls 1 auf das Halbleiterrelais 2 ist ebenso wie zur Demontage kein Werkzeug erforderlich.

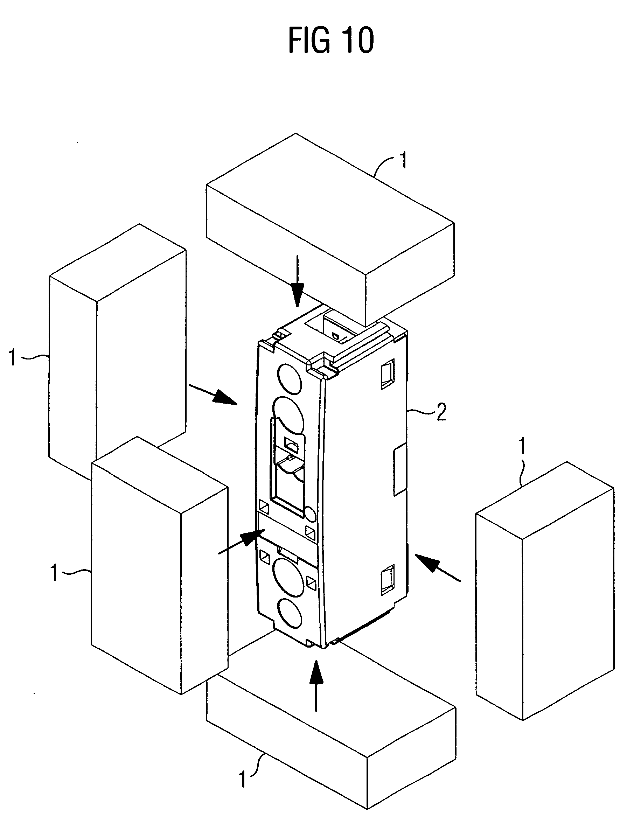

Das Ausführungsbeispiel nach FIG 10 zeigt ein Halbleiterrelais 2 sowie fünf lediglich symbolisch dargestellte Funktionsmodule 1, die an sämtlichen Anschlussseiten 4,5,6,7,8 des Gehäuses 20 befestigbar sind. Zusätzlich zur elektrischen und mechanischen Verbindung zwischen dem Halbleiterrelais 2 und den Funktionsmodulen 1 können solche Verbindungen auch in nicht näher dargestellter Weise zwischen den einzelnen Funktionsmodulen 1 vorgesehen sein.

## Patentansprüche

1. Halbleiterrelais (2) mit einem im Wesentlichen quaderförmigen Gehäuse (20), welches eine Befestigungsseite (3) sowie vier senkrecht zu dieser angeordnete Seitenflächen (4,5,6,7) und eine der Befestigungsseite (3) gegenüberliegende Frontseite (8) als Anschlussseiten (4,5,6,7,8) aufweist,
**dadurch gekennzeichnet, dass** dem Halbleiterrelais (2) an einer Anzahl Anschlussseiten (4,5,6,7,8) insgesamt mindestens ein elektrisches Verbindungselement (11,12) und mindestens ein mechanisches Verbindungselement (19,24) zum Anschluss eines mit dem Gehäuse (20) verbindbaren Funktionsmoduls (1) vorgesehen sind.

2. Halbleiterrelais (2) nach Anspruch 1, **wobei** das Halbleiterrelais (2) Mittel (24) zum Aufnehmen mehrerer mit dem Gehäuse (20) verbindbaren Funktionsmodule (1) aufweist.

3. Halbleiterrelais (2) nach Anspruch 1 oder 2, **wobei** das Halbrelais (2) zwei beidseitig einer Öffnung (26) des Gehäuses (20) angeordnete, parallel zu jeweils einer Seitenfläche (4,5,6,7) ausgerichtete Vertiefungen (24) für Befestigungsschenkel (25) aufweist.

4. Funktionsmodul (1), **dadurch gekennzeichnet, dass** das Funktionsmodul (1) mindestens eine Anschlussseite (15, 17) und Verbindmittel (21, 23, 25) aufweist, mit denen das Funktionmodul (1) zu einem Halbleiterrelais (2) nach einem der Ansprüche 1 bis 3 verbindbar ist.

5. Funktionsmodul (1) nach Anspruch 4, **wobei** dass das Funktionsmodul (1) zwei Anschlussseiten (15, 17) aufweist, mit denen das Funktionsmodul (1) zu einem Halbleiterrelais (2) nach einem der Ansprüche 1 bis 3 verbindbar ist.

6. Funktionsmodul (1) nach Anspruch 4 oder 5, **wobei** das Funktionsmodul (1) Mittel (21, 23, 25) zum werkzeuglosen Verbinden mit dem Gehäuse (20) des verbindbaren Funktionsmoduls (1) aufweist.

7. Funktionsmodul (1) nach Anspruch 4, 5, oder 6, **wobei** die Mittel (21, 23, 25) zum Aufschnappen des Funktionsmoduls (1) auf das Gehäuse (20) ausgebildet sind.

8. Funktionsmodul (1) nach einem der Ansprüche 4 bis 7, **wobei** das Funktionsmodul (1) zwei beidseitig einer Öffnung (26) des Gehäuses (20) angeordnete, parallel zu jeweils einer Seitenfläche (4,5,6,7) ausgerichtete Befestigungsschenkel (25) aufweist.

9. Funktionsmodul (1) nach einem der Ansprüche 4 bis 8, **wobei** das Funktionsmodul (1) ein Gerät zur Laststromkreisüberwachung, zur Leistungsregelung im Laststromkreis, zur Strommessung, und/oder zur Analog-Digital-Signalwandlung ist, und/oder ein mittels eines Analogsignals ansteuerbares Gerät ist.

10. Vorrichtung, **dadurch gekennzeichnet, dass** die Vorrichtung ein Halbleiterrelais (2) nach einem der Ansprüche 1 bis 3 und ein oder mehrere Funktionsmodule (1) nach einem der Ansprüche 4 bis 9 aufweist, wobei das Funktionsmodul/die Funktionsmodule mechanisch und elektrisch zu dem Halbleiterrelais (2) verbunden ist/sind.

11. Vorrichtung nach Anspruch 10, **wobei** die Vorrichtung ein mit zwei Anschlussseiten (15, 17) an das Halbleiterrelais (2) verbundenes Funktionsmodul (1) aufweist.

12. Vorrichtung nach Anspruch 10 oder 11, **wobei** das Funktionsmodul/die Funktionsmodule (1) eine mit der Befestigungsseite (3) des Gehäuses (20) fluchtende Basisseite (16) aufweist/aufweisen.

## Claims

1. Semiconductor relay (2) having an essentially cuboid housing (20), which has a mounting face (3) as well four side surfaces (4, 5, 6, 7), which are arranged at right angles to this mounting face (3), and a front face (8), which is opposite the mounting face (3), as connecting faces (4, 5, 6, 7, 8),
**characterized in that** a total of at least one electrical connection element (11, 12) and at least one mechanical connection element (19, 24) for connection of a function module (1) which can be connected to the housing (20) are provided on a number of connecting faces (4, 5, 6, 7, 8) on the semiconductor relay (2).

2. Semiconductor relay (2) according to Claim 1, wherein the semiconductor relay (2) has means (24) for holding a plurality of function modules (1) which can be connected to the housing (20).

3. Semiconductor relay (2) according to Claim 1 or 2, wherein the semiconductor relay (2) has two depressions (24), which are arranged on both sides of an opening (26) in the housing (20) and are each aligned parallel to one side surface (4, 5, 6, 7), for mounting limbs (25).

4. Function module (1), **characterized in that** the function module (1) has at least one connecting face (15, 17) and connection means (21, 23, 25), to which the function module (1) can be connected in order to form a semiconductor relay (2) according to one of Claims 1 to 3.

5. Function module (1) according to Claim 4, wherein the function module (1) has two connecting faces (15, 17), to which the function module (1) can be connected in order to form a semiconductor relay (2) according to one of Claims 1 to 3.

6. Function module (1) according to Claim 4 or 5, wherein the function module (1) has means (21, 23, 25) for connection to the housing (20) of the function module (1) which can be connected, without the use of tools.

7. Function module (1) according to Claim 4, 5 or 6, wherein the means (21, 23, 25) are designed for snapping the function module (1) onto the housing (20).

8. Function module (1) according to one of Claims 4 to 7, wherein the function module (1) has two mounting limbs (25), which are arranged on both sides of an opening (26) in the housing (20) and are each aligned parallel to one side surface (4, 5, 6, 7).

9. Function module (1) according to one of Claims 4 to 8, wherein the function module (1) is an appliance for loading circuit monitoring, for power regulation in the load circuit, for current measurement, and/or for analogue/digital signal conversion, and/or an appliance which can be driven by means of an analogue signal.

10. Apparatus, **characterized in that** the apparatus has a semiconductor relay (2) according to one of Claims 1 to 3 and one or more function modules (1) according to one of Claims 4 to 9, wherein the function module or modules is or are mechanically and electrically connected in order to form the semiconductor relay (2).

11. Apparatus according to Claim 10, wherein the apparatus has a function module (1) which is connected by two connecting faces (15, 17) to the semiconductor relay (2).

12. Apparatus according to Claim 10 or 11, wherein the function module or modules (1) has or have a base face (16) which is aligned with the mounting face (3) of the housing (20).

## Revendications

1. Relais (2) à semiconducteur ayant un boîtier (20) sensiblement parallélépipédique qui a un côté (3) de fixation ainsi que quatre faces (4, 5, 6, 7) latérales qui lui sont perpendiculaires et un côté (8) avant opposé au côté (3) de fixation, en tant que côtés (4, 5, 6, 7, 8) de connexion, **caractérisé en ce qu'**au relais (2) à semiconducteur sur un certain nombre de côtés (4, 5, 6, 7, 8) de connexion, il est prévu dans l'ensemble au moins un élément (11, 12) de liaison électrique et au moins un élément (19, 24) de liaison mécanique pour la connexion d'un module (1) fonctionnel pouvant être relié au boîtier (20).

2. Relais (2) à semiconducteur suivant la revendication 1, dans lequel le relais (2) à semiconducteur à des moyens (24) de réception de plusieurs modules (1) fonctionnels pouvant être reliés au boîtier (20).

3. Relais (2) à semiconducteur suivant la revendication 1 ou 2, dans lequel le relais (2) à semiconducteur a deux cavités (24) de branches (25) de fixation, disposées des deux côtés d'une ouverture (26) du boîtier (20) et dirigées respectivement vers une face (4, 5, 6, 7) latérale.

4. Module (1) fonctionnel, **caractérisé en ce que** le module (1) fonctionnel a au moins un côté (15, 17) de connexion et des moyens (21, 23, 25) de liaison, par lesquels le module (1) fonctionnel peut être relié à un relais (2) à semiconducteur suivant l'une des revendications 1 à 3.

5. Module (1) fonctionnel, suivant la revendication 4, **caractérisé en ce que** le module (1) fonctionnel a deux côtés (15, 17) de connexion et des moyens (21, 23, 25) de liaison, par lesquels le module (1) fonctionnel peut être relié à un relais (2) à semiconducteur suivant l'une des revendications 1 à 3.

6. Module (1) fonctionnel suivant la revendication 4 ou 5, dans lequel le module (1) fonctionnel a des moyens (21, 23, 25) de liaison sans outil avec le boîtier (20) du module (1) fonctionnel pouvant être relié.

7. Module (1) fonctionnel suivant la revendication 4, 5 ou 6, dans lequel les moyens (21, 23, 25) sont constitués pour encliqueter le module (1) fonctionnel sur le boîtier (20).

8. Module (1) fonctionnel suivant l'une des revendications 4 à 7, dans lequel le module (1) fonctionnel a deux branches (25) de fixation, disposées des deux côtés d'une ouverture (26) du boîtier (20) et dirigées parallèlement à respectivement une surface (4, 5, 6, 7)latérale.

9. Module (1) fonctionnel suivant l'une des revendications 4 à 8, dans lequel le module (1) fonctionnel est un appareil pour contrôler le circuit du courant de charge, pour réguler la puissance dans le circuit de courant de charge, pour mesurer le courant et/ou pour la transduction de signal analogique/numérique et/ou un appareil pouvant être commandé au moyen d'un signal analogique.

10. Dispositif **caractérisé en ce que** le dispositif comporte un relais (2) à semiconducteur suivant l'une des revendications 1 à 3, et un ou plusieurs modules (1) fonctionnels suivant l'une des revendications 4 à 9, le module fonctionnel ou/les modules fonctionnels étant relié mécaniquement et électriquement au relais (2) à semiconducteur.

11. Dispositif suivant la revendication 10, dans lequel le dispositif a un module (1) fonctionnel relié à deux côtés (15, 17) de connexion sur le relais (2) à semiconducteur.

12. Dispositif suivant la revendication 10 ou 11, dans lequel le/les modules (1) fonctionnels a/ont un côté (16) de base aligné avec le côté (3) de fixation du boîtier (20).
